# EUROPEAN PATENT APPLICATION

(11) **EP 3 680 142 A1**
(43) Date of publication of application: **15.07.2020**
(21) Application number: 18853581.9
(22) Date of filing: 27.03.2018
(51) Int. Cl.: B61C 17/00, F28D 15/02, H01L 23/427, H02M 7/48, H05K 7/20

(54) **POWER CONVERSION DEVICE FOR RAIL CARS AND RAIL CAR EQUIPPED WITH POWER CONVERSION DEVICE**

(30) Priority: 08.09.2017 JP 2017172833
(71) Applicant: Hitachi, Ltd., Tokyo 100-8280 (JP)
(72) Inventor: FUNAKOSHI, Sunao, Tokyo 100-8280 (JP); YASUDA, Yosuke, Tokyo 100-8280 (JP); NISHIHARA, Atsuo, Tokyo 100-8280 (JP); TERAKADO, Shuichi, Tokyo 100-8280 (JP); HORIUCHI, Keisuke, Tokyo 100-8280 (JP); HATA, Kunihiko, Tokyo 100-8280 (JP)
(74) Representative: Mewburn Ellis LLP
(86) International application number: PCT/JP2018/012293
(87) International publication number: WO 2019/049405

(57) **Abstract**

Provided is a highly-reliable cooling structure for a power conversion device for rail cars which uses a self-oscillating heat pipe for cooling, wherein a decrease in cooling performance due to impact by a flying object or the like is avoided. Accordingly, this power conversion device for rail cars is composed of a plurality of power semiconductor elements and comprises a self-oscillating heat pipe which cools the power semiconductor elements. The self-oscillating heat pipe is, for example, structured such that the interior of a heat sink member exposed to a cooling airflow has sealed flow paths wherein a working fluid is sealed. The thickness of end partition walls of the self-oscillating heat pipe, each of which is in contact with an airflow inlet portion or an outlet portion, is greater than the thickness of an internal partition wall separating the flow path.

## Description

### Technical Field

The present invention relates to a power conversion device for rail cars and, particularly, to a cooling structure for the power conversion device.

### Background Art

A power conversion device for rail cars is used to control an electric motor that drives electric rail cars or the like and installed, inter alia, under the floor of a rail car. Because space under the floor of a rail car among others is limited, it is desired to cool power semiconductor elements of the power conversion device efficiently with a cooling structure that is as small as possible.

As a conventional cooling structure for a power conversion device for rail cars, as set forth in Patent Literature 1, a structure is known in which a heat receiving member is vertically installed under the car body, semiconductor elements are installed on one side of the heat receiving member, and a heat pipe is installed on the other side of the heat receiving member, and heat of the semiconductor elements is dissipated into air by exposing fins installed to the heat pipe to wind generated by running of the rail car.

Besides, as an example in which a self-oscillating heat pipe is applied to cool semiconductor elements like those of a central processing unit, like an element heat sink set forth in Patent Literature 2, a cooling structure is known in which a heat receiving plate is placed on top of heat generating elements and a plate like a meandering perforated plate is connected on top of the heat receiving member.

### Citation List

### Patent Literature

Patent Literature 1: Japanese Patent Application Laid-Open No. 2011-50166
Patent Literature 2: Japanese Patent Application Laid-Open No. 2006-80471

### Summary of Invention

### Technical Problem

The present inventors concentrated on examinations on downsizing a power conversion device for rail cars and, as a result hereof, have obtained knowledge described below.

Even for a structure in which a power conversion device for rail cars is installed in space under the floor of a rail car, there is a case where the space under the floor has no room to provide a sufficient height, e.g., like some of subway cars. In such a case, when power semiconductor elements are placed onto the heat receiving member put vertically in a conventional way, a total height which is determined by the sizes of the elements becomes too high. To cope with this, it is conceivable that the height of the power conversion device can be decreased by placing the heat receiving member horizontally, placing power semiconductor elements on top of that member, and placing a cooler onto the underside of the heat receiving member.

Nevertheless, for conventional heat pipe coolers, it is impossible to apply a so-called top heat placement in which a heat dissipation part is placed under the heat receiving member, because a condensate liquid within a heat pipe circulates by gravity. Besides, in a case where cooling is performed with a structure in which the heat receiving member is provided with simple plate fins, cooling performance is lower as compared with heat pipes and it is impossible to cool power semiconductor elements sufficiently.

On the other hand, in a case where self-oscillating heat pipes for which a top-heat placement is possible are applied to rail cars, there is a possibility that ballast and other small flying objects collide with a lower part of the cars. Because self-oscillating heat pipes are thin and weak, when a flying object collides with a self-oscillating heat pipe in a previously noted conventional structure, it is feared that a hole is opened in the heat pipe by impact and a working fluid in an internal flow path leaks out. Leakage of the working fluid results in insufficient cooling performance and rise of temperature of power semiconductors in the power conversion device and leads to damage to the semiconductors in the worst case.

An object of the present invention is to provide a cooler of a power conversion device for rail cars, the cooler having a smaller structure and its cooling performance not decreasing even due to collision of a flying object or the like against it.

### Solution to Problem

To solve the above-noted problem, a power conversion device for rail cars pertaining to the present invention comprises a self-oscillating heat pipe for cooling power semiconductor elements, the self-oscillating heat pipe having, for example, a structure comprising a sealed flow path in which a working fluid is sealed inside a heat sink member exposed to a cooling airflow. Thickness of end partition walls of the self-oscillating heat pipe, each wall abutting on a cooling airflow inlet portion or outlet portion, is made thicker than the thickness of internal partition walls separating the flow path.

### Advantageous Effects of Invention

According to the present invention, it can be avoided that a hole is opened in a weak flow path of a self-oscillating heat pipe due to collision of a flying object or the like against the pipe, a working fluid leaks out, and cooling performance deteriorates and, therefore, it is possible to provide a highly reliable power conversion device for rail cars.

### Brief Description of Drawings

Fig. 1 is a diagram depicting a cooler of a power conversion device pertaining to a first embodiment, viewed from a direction of movement.
Fig. 2 is a perspective view of the cooler depicted in Fig. 1.
Fig. 3 is a diagram depicting a structure of a flat self-oscillating heat pipe for use in the cooler pertaining to the first embodiment.
Fig. 4 is a diagram depicting a folded-back structure of the flat self-oscillating heat pipe for use in the cooler pertaining to the first embodiment.
Fig. 5 is a diagram depicting a thickness-wise cross section of the self-oscillating heat pipe for use in the cooler pertaining to the first embodiment.
Fig. 6 is a diagram depicting a structure of a heat dissipation part in which plural self-oscillating heat pipes are arranged along a direction of running wind.
Fig. 7 is a diagram depicting a placement composition of a power conversion device pertaining to respective embodiments of the present invention when installed onto a rail car.
Fig. 8 is a diagram depicting another placement composition of the power conversion device pertaining to the present invention when installed onto a rail car.
Fig. 9 is a diagram depicting yet another placement composition of the power conversion device pertaining to the present invention when installed onto a rail car.
Fig. 10 is a diagram depicting a structure of the heat dissipation part with self-oscillating heat pipes with regard to a power conversion device pertaining to a second embodiment of the present invention.
Fig. 11 is a perspective view depicting a structure of the heat dissipation part with regard to a power conversion device pertaining to a third embodiment of the present invention.
Fig. 12 is a side view of the heat dissipation part of the power conversion device pertaining to the third embodiment.

### Description of Embodiments

First thru third embodiments, as embodiments of the present invention, will be described below with the aid of the drawings.

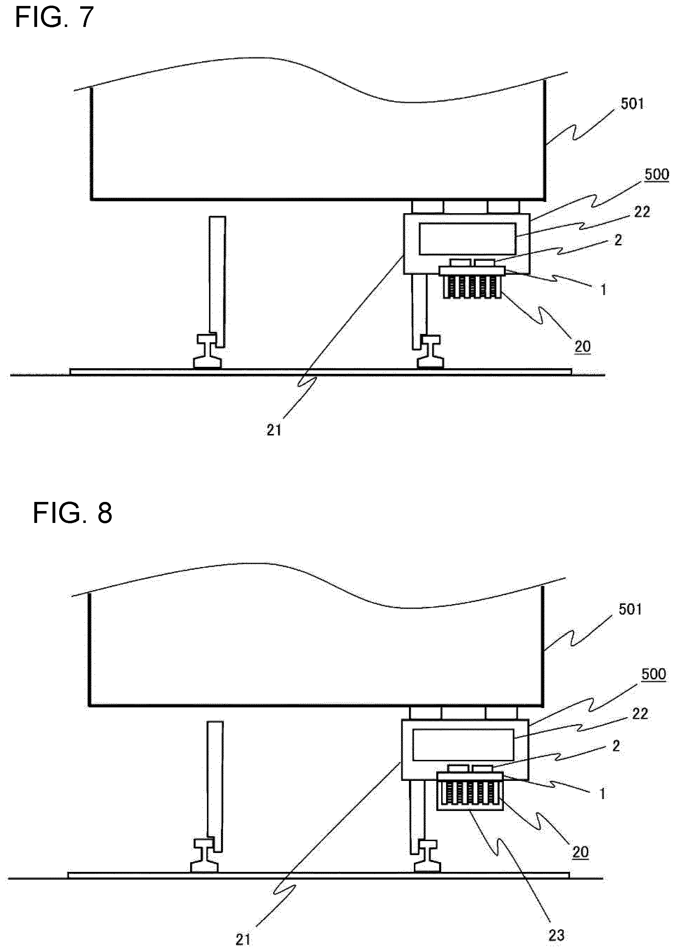

Fig. 7 is a diagram depicting a placement composition of a power conversion device pertaining to the respective embodiments of the present invention when installed onto a rail car. A power conversion device pertaining to the present invention is installed, inter alia, under the floor of a rail car and performs control of rotational speed of an electric motor by changing the frequency of electric power to be supplied to the electric motor that drives the car.

A power conversion device 500 depicted in Fig. 8 is fixed in a state suspended from the car body 501. Power semiconductor elements 2 are mounted on top of a heat receiving plate 1 and a heat dissipation part 20 using a self-oscillating heat pipe is installed onto the underside of the heat receiving plate 1 on its opposite side. The power semiconductor elements 2 and other electronic components 22 including capacitors, controllers, etc. etc. are sealed in a case 21.

### First Embodiment

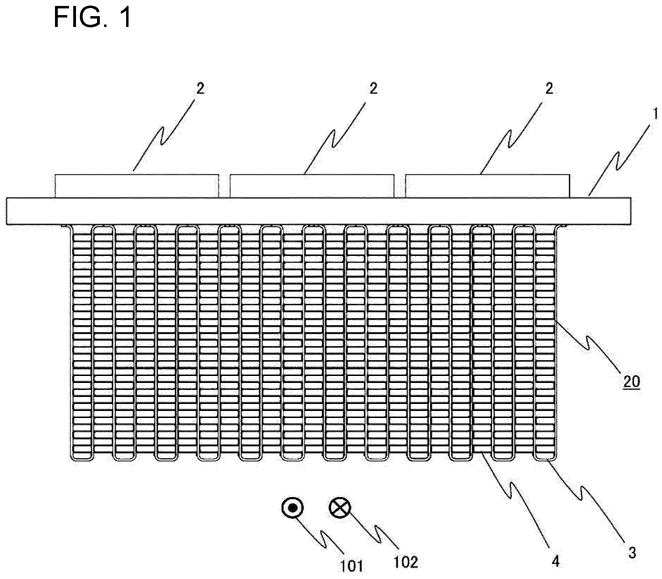

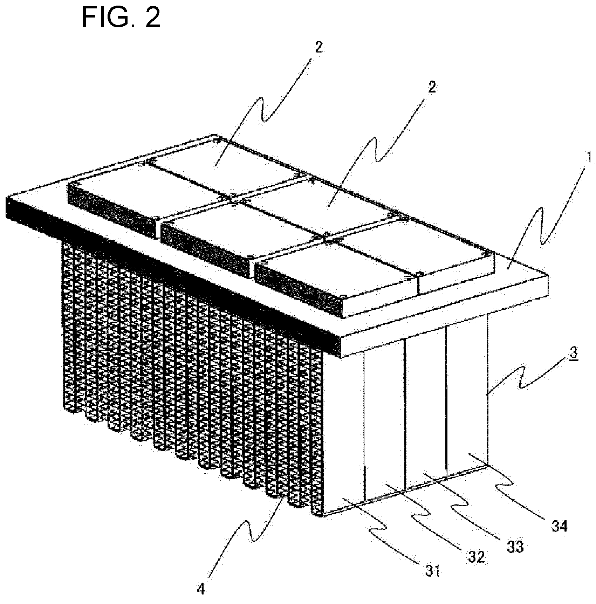

Fig. 1 is a diagram depicting a cooler of a power conversion device pertaining to a first embodiment, viewed from a direction of movement and Fig. 2 is a perspective view of this cooler. Arrows 101 and 102 in Fig. 1 indicate the directions of a running wind generated by movement of the car. Because the car moves either forward or backward, the running wind is to be generated accordingly in either direction of the arrows 101 and 102.

In Fig. 1 and Fig. 2, power semiconductor modules 2 including plural power semiconductor elements such as IGBT (Insulated Gate Bipolar Transistors) are placed on top of a heat receiving member 1 which is made of metal such as an aluminum alloy and the plural power semiconductor modules 2 constitute the power conversion device. In the following, these power semiconductor modules will also referred to as power semiconductor elements.

The power semiconductor elements are fixed to the heat receiving member with screws or the like (not depicted) with a member such as grease (not depicted) intervening in between. The heat dissipation part 20 which is a heat sink member is set up on a reverse surface of the heat receiving member 1 opposite to the surface on which the power semiconductor elements are placed.

The heat dissipation part 20 depicted in Fig. 1 is comprised of a self-oscillating heat pipe 3 and corrugated fins 4 made of an aluminum alloy among others. The heat receiving member 1 and the self-oscillating heat pipe 3 are fastened together by brazing or the like. Besides, in a case where the flow path length of flow path length of the self-oscillating heat pipe 3 becomes too long, the self-oscillating heat pipe 3 may have a structure in which it is divided into split types 31 to 34 along the direction of movement, as depicted in Fig. 2.

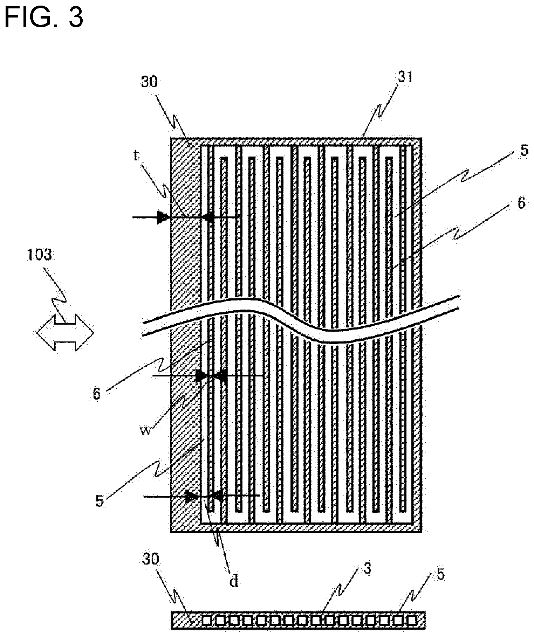

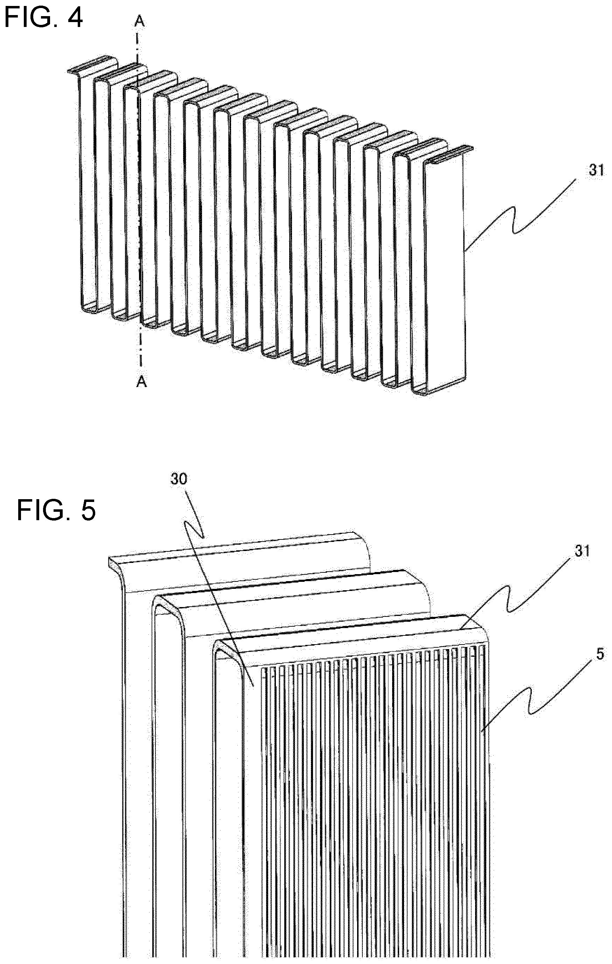

Fig. 3 is a diagram depicting a structure of a flat self-oscillating heat pipe (a split type 31), in which an arrow 103 indicates a direction of running wind and its cross section cut long the running wind direction 103 is depicted in a lower part of the diagram. Besides, Fig. 4 is a diagram depicting a folded-back structure of the flat self-oscillating heat pipe (the split type 31). The self-oscillating heat pipe (the split type 31) depicted in Fig. 1 and Fig. 2 is configured by folding the flat self-oscillating heat pipe 31 having the structure depicted in Fig. 3 as depicted in Fig. 4.

As for an internal structure of the self-oscillating heat pipe 31, a meandering flow path 5 through which, e.g., a working fluid flows, as a sealed flow path in which the working fluid is sealed, and internal partition walls 6 separating the flow path are provided, as depicted in Fig. 3. Besides, Fig. 5 depicts a thickness-wise cross section of the self-oscillating heat pipe 31 (a cross section along line A-A in Fig. 4). As the working fluid, water, fluorinates, alternative chlorofluorocarbons, alcohols, hydrocarbons such as butane, hydrofluoroethers, or perfluoroketones are used.

Then, an operating behavior of the cooler pertaining to the present invention is described.

Loss arising from the power semiconductor elements 2 when operating becomes heat and the heat is transferred through the heat receiving member 1 to the self-oscillating heat pipe 3. The heat is transferred to a distal end portion (downstream end) of the self-oscillating heat pipe 3 by oscillation of the working fluid sealed in the flow path 5 of the self-oscillating heat pipe 3 within the flow path. The heat is further transferred from the self-oscillating heat pipe 3 to the corrugated fins 4. When the running wind 101 or 102 (Fig. 1) generated by running of the car passes between the corrugated fins 4, the heat is dissipated from the surfaces of the corrugated fins 4 and the self-oscillating heat pipe 3 into air.

Besides, in the structure of the self-oscillating heat pipe 3, thickness of an end partition wall 30 abutting on a cooling airflow inlet portion (an outlet portion if the running wind direction is opposite) is made thicker than the internal partition walls 6, as depicted in Fig. 3 and Fig. 5. This structure makes an increase in strength of the self-oscillating heat pipe 3 in the vicinity of its portion exposed to cooling airflow and prevents that a hole or the like is opened in the self-oscillating heat pipe 3 when a flying object such as ballast collides with the pipe or in other situations. This enables it to prevent that the working fluid flowing in the flow path 5 leaks out, resulting in that the oscillating heat pipe does not work well and heat dissipation performance deteriorates. It is preferable to ensure sufficient strength by making the thickness (marked "t" in Fig. 3) of the end partition wall 30 abutting on the cooling air inlet portion and outlet portion, at least, equal to or thicker than a thickness as the sum of the thickness (marked "w" in Fig. 3) of an internal partition wall and the width (marked "d" in Fig. 3) of the flow path 5 along the direction of cooling airflow (t ≥ w + d) .

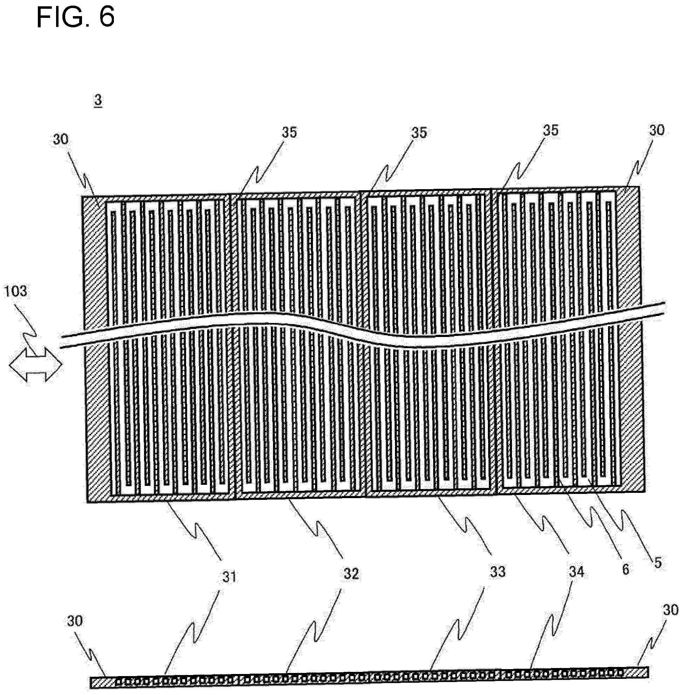

Fig. 6 is a diagram depicting a structure of the heat dissipation part configured such that plural self-oscillating heat pipes are arranged along the running wind direction 103 and its cross section cut long the running wind direction 103 is depicted in a lower part of the diagram. In Fig. 6, an example of division into four self-oscillating heat pipes 31 to 34 is presented and the thickness of the end partition walls 30 of pipes 31 and 34 abutting on the cooling airflow inlet portion and outlet portion among these pipes is made thicker than the end partition walls 35 of remaining other pipes. That is, the end partition walls 35 of self-oscillating heat pipes 32 and 33 put in intermediate positions are made thinner to enhance a heat dissipation effect. And now, to reduce sorts of self-oscillating heat pipes, this structure may be comprised of one sort of self-oscillating heat pipe with thicker end partition walls at both ends.

Fig. 8 is a diagram depicting another placement composition of the power conversion device pertaining to the present invention when installed onto a rail car. Difference from the placement composition in Fig. 7 lies in that a cover 23 is provided around the heat dissipation part 20 which is comprised of a self-oscillating heat pipe. The cover 23 is made of metal such as aluminum and this enables it to prevent the self-oscillating heat pipe from being damaged when ballast or the like collides with a lateral surface or a bottom surface of the heat dissipation part 20. Additionally, by providing a cover such as a punching plate also on the front and back surfaces of the heat dissipation part 20, it can be avoided that a large flying object directly collides with the heat dissipation part.

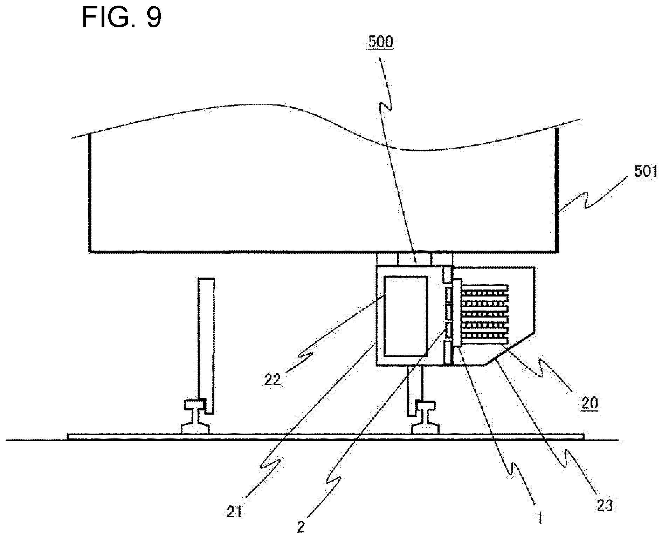

Fig. 9 is a diagram depicting yet another placement composition of the power conversion device pertaining to the present invention when installed onto a rail car. Unlike the placement compositions depicted in Fig. 7 and Fig. 8, a power conversion device 500 may be installed so that the heat receiving member 1 is put in a vertical direction, depending on placement of circumjacent units and space, thereby the heat dissipation part 20 is oriented in a horizontal direction in this structure. And now, in Fig. 9, the structure is presented in which the cover 23 is provided around the heat dissipation part 20 as with Fig. 8.

As noted previously, according to the placement compositions depicted in Fig. 8 and Fig 9, it can be prevented that, when a flying object such as ballast collides with the self-oscillating heat pipe 3, a hole is opened in the self-oscillating heat pipe and heat dissipation performance deteriorates.

### Second Embodiment

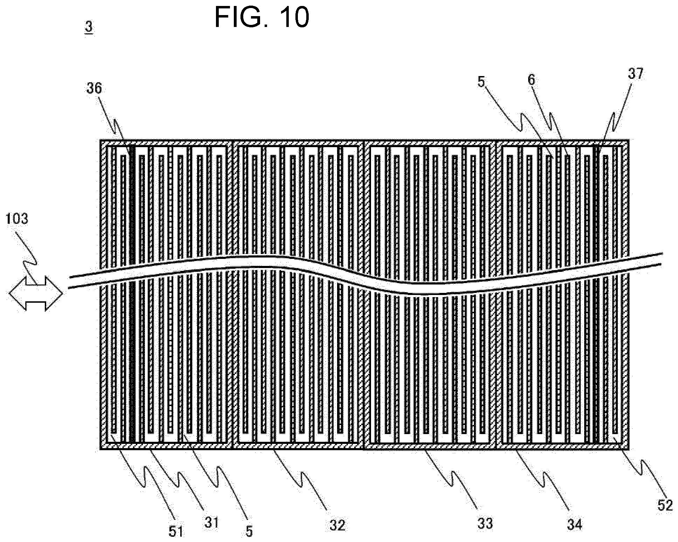

Fig. 10 is a diagram depicting a structure of the heat dissipation part with self-oscillating heat pipes with regard to a power conversion device pertaining to a second embodiment of the present invention. And now, the same parts as in the first embodiment are assigned the same numbers in the drawing. Also, the placement composition when installed onto a rail car and the entire structure are the same as in the first embodiment.

In Fig. 10, an arrow 103 indicates a direction of running wind and bulkhead walls 36 and 37 for heat pipes are provided in self-oscillating heat pipes 31 and 34 positioned in an inlet portion and an outlet portion along the direction of running wind 103 to give completely separate and independent flow paths of the working fluid. Against these bulkhead walls 36 and 37, the length of flow paths 51 and 52 nearest to the running wind inlet portion and outlet portion is made shorter than a main flow path 5. And now, a working fluid may not be sealed in the flow paths 51 and 52. By this structure, it is avoided that the working fluid leaks out from the main flow path 5 existing in an opposite side of the bulkhead wall 36 (in interior heat pipes), even in case a hole should be opened in the portions of the flow paths 51 and 52 among the flow paths of the working fluid, as a flying object such as ballast should collide with these portions. Therefore, heat dissipation performance can be prevented from deteriorating.

### Third Embodiment

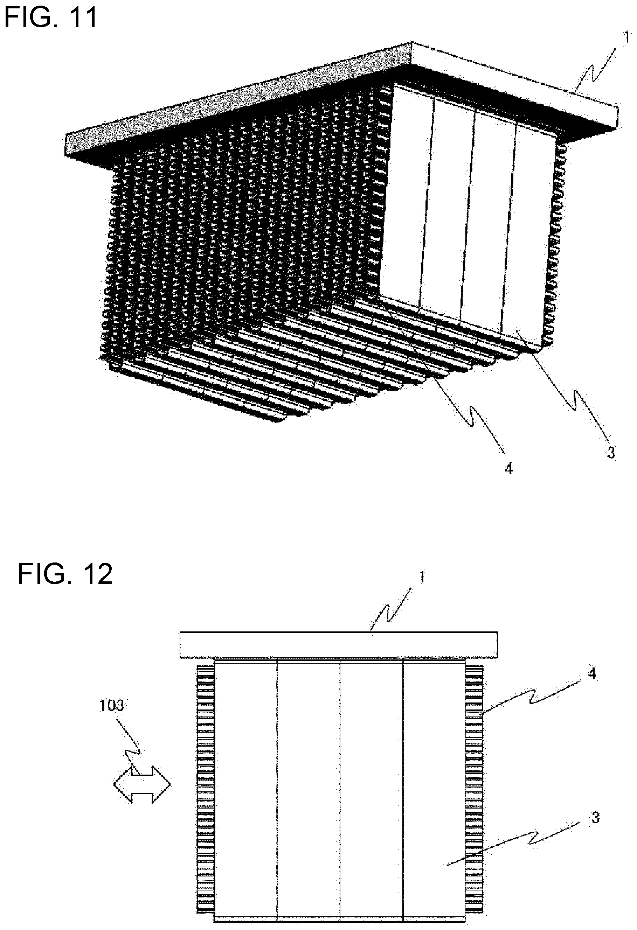

Fig. 11 is a perspective view depicting a structure of the heat dissipation part with regard to a power conversion device pertaining to a third embodiment of the present invention and Fig. 12 is a side view of the heat dissipation part. As depicted in Fig. 11 and Fig. 12, in the third embodiment, the heat dissipation part is installed such that portions of the corrugated fins 4 adjacent to the cooling airflow inlet protrude out of the working fluid flow path 3 along the direction of running wind 103. By this structure, even if a flying object such as ballast should collide with the heat dissipation part, the portions of the corrugated fins 4 protruding outward will absorb impact by being deformed and no hole will be opened in the working fluid flow path 3. Therefore, heat dissipation performance can be prevented from deteriorating.

### List of Reference Signs

1: heat receiving member, 2: power semiconductor element, 3: self-oscillating heat pipe, 4: corrugated fins, 5 (51, 52): flow path of working fluid, 6: internal partition walls of flow path, 20: heat dissipation part, 21: case, 22: electronic components, 23: cover, 30: end partition wall in cooling airflow inlet portion and outlet portion, 31-34: slit types of self-oscillating heat pipes, 35: end partition wall of heat pipe, 36, 37: bulkhead walls within heat pipes, 101-103: direction of running wind, 500: power conversion device, 501: car body

## Claims

1. A power conversion device for rail cars which is composed of a plurality of power semiconductor elements, comprising:
a self-oscillating heat pipe for cooling the power semiconductor elements,
the self-oscillating heat pipe having a structure comprising a sealed flow path in which a working fluid is sealed inside a heat sink member exposed to a cooling airflow,
**characterized in that** thickness of end partition walls of the self-oscillating heat pipe, each wall abutting on a cooling airflow inlet portion or outlet portion, is made thicker than the thickness of internal partition walls separating the flow path.

2. The power conversion device for rail cars according to claim 1,
**characterized in that**, in the self-oscillating heat pipe, internal partition walls separating the flow path are arranged in order in along a direction of cooling airflow.

3. The power conversion device for rail cars according to claim 1 or 2,
**characterized in that** the self-oscillating heat pipe is configured such that the heat sink member having a flat plate shape is formed into profiles folded back once or more times in a direction that is substantially perpendicular to the cooling airflow direction and heat dissipation fins are provided between the folded-back profiles.

4. The power conversion device for rail cars according to any one of claims 1 to 3,
**characterized in that** the thickness of the end partition walls is equal to or thicker than the sum of the thickness of each of the internal partition walls and the width of the flow path along the cooling airflow direction.

5. The power conversion device for rail cars according to any one of claims 1 to 4,
**characterized in that** the self-oscillating heat pipe is configured to be divided into one or more parts in the cooling airflow direction.

6. A power conversion device for rail cars which is composed of a plurality of power semiconductor elements, comprising:
a self-oscillating heat pipe for cooling the power semiconductor elements,
the self-oscillating heat pipe having a structure comprising a sealed flow path in which a working fluid is sealed inside a heat sink member exposed to a cooling airflow and internal partition walls separating the flow path and arranged in order in a direction of cooling airflow,
**characterized in that** sections of the flow path nearest to the cooling airflow inlet portion or outlet portion are separate and independent from the flow path inner than the sections of the flow path by bulkhead walls.

7. The power conversion device for rail cars according to claim 6,
**characterized in that** the self-oscillating heat pipe is configured such that the heat sink member having a flat plate shape is formed into profiles folded back once or more times in a direction that is substantially perpendicular to the cooling airflow direction and heat dissipation fins are provided between the folded-back profiles.

8. The power conversion device for rail cars according to claim 6 or 7,
**characterized in that** the self-oscillating heat pipe is configured to be divided into one or more parts in the cooling airflow direction.

9. A power conversion device for rail cars which is composed of a plurality of power semiconductor elements, comprising:
a self-oscillating heat pipe for cooling the power semiconductor elements,
the self-oscillating heat pipe comprising a sealed flow path in which a working fluid is sealed inside heat sink members exposed to a cooling airflow and heat dissipation fins provided between the heat sink members
**characterized in that** the heat dissipation fins have a structure in which their cooling airflow inlet portion or outlet portion protrude outward from the cooling air inlet portion or outlet portion of the self-oscillating heat pipe.

10. The power conversion device for rail cars according to claim 9,
**characterized in that** the self-oscillating heat pipe is configured such that the heat sink members having a flat plate shape are formed into profiles folded back once or more times in a direction that is substantially perpendicular to the cooling airflow direction and the heat dissipation fins are provided between the folded-back profiles.

11. The power conversion device for rail cars according to any of claims 1 to 10, **characterized in that** the self-oscillating heat pipe is placed onto the underside of a heat receiving member with the power semiconductor elements mounted thereon.

12. The power conversion device for rail cars according to any of claims 1 to 11,
**characterized in that** a cover is provided around a heat dissipation part comprising the self-oscillating heat pipe.

13. A rail car equipped with the power conversion device for rail cars described in any one of the claims 1 to 12.
